(19) Europäisches Patentamt
European Patent Office
Office européen des brevets

(11) **EP 3 159 703 A1**

(12) **DEMANDE DE BREVET EUROPEEN**

(43) Date de publication:
26.04.2017 Bulletin 2017/17

(51) Int Cl.:
*G01Q 10/04* (2010.01)    *B81B 3/00* (2006.01)
*G01Q 20/04* (2010.01)

(21) Numéro de dépôt: **16193853.5**

(22) Date de dépôt: **14.10.2016**

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**
Etats d'extension désignés:
**BA ME**
Etats de validation désignés:
**MA MD**

(30) Priorité: **23.10.2015 FR 1560144**

(71) Demandeurs:
• **Vmicro**
**59652 Villeneuve d'Ascq (FR)**

• **CENTRE NATIONAL DE LA RECHERCHE SCIENTIFIQUE**
**75016 Paris (FR)**

(72) Inventeurs:
• **WALTER, Benjamin**
**59000 LILLE (FR)**
• **FAUCHER, Marc**
**59810 LESQUIN (FR)**

(74) Mandataire: **Priori, Enrico et al**
**Marks & Clerk France**
**Conseils en Propriété Industrielle**
**Immeuble «Visium»**
**22, avenue Aristide Briand**
**94117 Arcueil Cedex (FR)**

(54) **DISPOSITIF ET SYSTEME MICROELECTROMECANIQUE AVEC TRANSDUCTEUR RESISTIF A FAIBLE IMPEDANCE**

(57) Dispositif microélectromécanique comprenant une structure mécanique (P1) s'étendant principalement selon une direction longitudinale (x), reliée à un substrat planaire (S) par au moins un ancrage (APLM, APLM2) situé à l'une de ses extrémités et susceptible de fléchir dans un plan parallèle au substrat, ladite structure mécanique comprenant une portion de raccord, qui la relie audit ou à chaque dit ancrage et qui inclut une région résistive (R1) présentant une première (PL1M1) et une deuxième (12) zone d'injection d'un courant électrique pour former un transducteur résistif, ladite région résistive s'étendant principalement dans ladite direction longitudinale à partir dudit ou d'un dit ancrage et étant agencée de telle sorte qu'une flexion de ladite structure mécanique dans ledit plan parallèle au substrat induise dans ladite région résistive une contrainte moyenne non nulle et réciproquement; caractérisé en ce que : ladite première zone d'injection est portée par ledit ancrage ; et ladite deuxième zone d'injection est portée par un élément conducteur non fixé audit substrat et s'étendant principalement dans une direction dite latérale, sensiblement perpendiculaire à ladite direction longitudinale.

Fig. 3a

EP 3 159 703 A1

**Description**

L'invention porte sur un dispositif et un système microélectromécanique. Plus particulièrement, elle porte sur un dispositif microélectromécanique comprenant un transducteur de type résistif permettant d'actionner et/ou détecter un mouvement de flexion « dans le plan » d'une structure mécanique de forme allongée, ainsi que sur un système microélectromécanique comprenant de tels dispositifs.

Il est bien connu de réaliser des systèmes microélectromécaniques (MEMS, de l'anglais Micro Electro Mechanical System) comportant une structure mécanique de type poutre encastrée (« cantilever ») s'étendant à partir du bord d'un substrat planaire et pouvant fléchir dans un plan perpendiculaire à celui du substrat. De telles structures ont été utilisées, notamment, pour réaliser des sondes de microscope à force atomique. Elles fonctionnent bien dans le vide ou dans l'air, mais pas en milieu liquide car les vibrations de la poutre sont alors fortement amorties par la viscosité du milieu. Pour résoudre ce problème, on a été amené à développer des MEMS présentant une structure mécanique de type poutre fléchissant dans le plan du substrat ou présentant un mouvement de translation dans ce même plan. Dans ce dernier cas, la poutre peut être rigide et son mouvement de translation être induit par la flexion - également dans le plan - d'un ou plusieurs bras latéraux de soutien.

Il existe donc un besoin pour un système microélectromécanique permettant d'actionner - et de détecter - un mouvement de flexion dans le plan d'une structure de type poutre (ou, plus généralement, présentant une forme allongée).

Un certain nombre de travaux de recherche ont proposé de répondre à ce besoin en utilisant des actionneurs de type thermique et des détecteurs piézo-résistifs. Une telle solution présente l'avantage d'être compatible avec l'utilisation d'un grand nombre de matériaux contrairement, par exemple, à une transduction piézoélectrique. En outre une même structure peut servir à la fois d'actionneur thermique (la chaleur étant produite par effet Joule) et de détecteur piézo-résistif.

L'article de J. H. Comtois, V. M. Bright et M. W. Phipps « Thermal microactuators for surface-micromachining processes », Proc.

SPIE 2642, Micromachined Devices and Components, 10 (15 septembre 1995) décrit une structure de flexion en silicium, composée deux bras parallèles, reliés entre eux par leur extrémité distale (opposée aux ancrages) et portant une piste résistive formant un « U », qui permet de faire circuler un courant entre les deux ancrages. Ce courant engendre de la chaleur par effet Joule ; un des bras (« bras froid ») est volontairement grossi pour favoriser des échanges convectifs avec l'extérieur et diminuer la densité de puissance dans le silicium ; ainsi ce bras chauffe moins que l'autre (dit « bras chaud »). La dilatation thermique plus importante du bras chaud provoque alors une flexion de la structure dans le plan. Cette structure est conçue pour un fonctionnement statique ; en tout cas, la masse relativement importante du bras froid pénaliserait toute montée en fréquence. En outre, la piste résistive présente nécessairement une longueur importante (environ deux fois celle de la structure), et donc une résistance élevée. Or, afin d'obtenir un transfert de puissance efficace entre le transducteur et des appareils électroniques externes (alimentations, générateurs de signaux, circuits de mesure...) il conviendrait que le transducteur ait une impédance aussi proche que possible de 50 $\Omega$ (Ohms).

L'article de L. A. Beardslee, A. M. Addous, S. Heinrich, F. Josse, I. Dufour et O. Brand « Thermal Excitation and Piezoresistive Detection of Cantilever In-Plane Resonance Modes for Sensing Applications » Journal of Microelectromechanical Systems, Vol. 19, No. 4, août 2010 décrit une structure comportant une poutre en silicium encastrée à une extrémité et portant, près de son ancrage et sur des côtés opposés, deux résistances obtenues par dopage. Des pistes métalliques connectent les extrémités des résistances et permettent d'y injecter un courant électrique. L'injection d'un courant dans la résistance de droite provoque un échauffement par effet Joule, qui à son tour induit une dilatation thermique du côté droit de la poutre et donc sa flexion vers la gauche ; réciproquement en cas d'injection de courant dans la résistance de gauche. Une structure formant un pont de Wheatstone - également obtenue grâce à des régions résistives fabriquées par dopage et interconnectées par des pistes métalliques - permet une mesure de la flexion par effet piézo-résistif. La largeur de la poutre va de 45 et 90 microns et sa longueur de 200 à 1000 microns ; il s'agit donc d'une structure de taille relativement importante. Une miniaturisation poussée - par exemple en prenant une largeur de 5 $\mu$m - se heurterait à plusieurs problèmes ; en particulier, il serait nécessaire d'utiliser des pistes conductrices très fines et très rapprochées ce qui conduirait à des difficultés d'isolation et à une impédance élevée.

D'une manière plus générale, l'art antérieur ne permet pas d'obtenir des transducteurs de type résistif (actionneurs thermiques et/ou capteurs piézo-résisitfs) qui soient à la fois miniaturisables - ce qui est nécessaire pour permettre un fonctionnement à fréquence élevée (supérieure ou égale à 1 MHz) - et de faible impédance (inférieure ou égale à 100 $\Omega$, de préférence sensiblement égale à 50 Q) - ce qui permet un transfert de puissance électrique efficace.

L'invention vise à surmonter ces inconvénients de l'art antérieur.

Un objet de l'invention, permettant d'atteindre ce but, est un dispositif microélectromécanique comprenant une structure mécanique s'étendant principalement selon une direction dite longitudinale, reliée à un substrat planaire parallèle à ladite direction longitudinale par au moins un ancrage situé à l'une de ses extrémités selon ladite direction longitudinale et susceptible de fléchir dans un plan parallèle au substrat, ladite structure mécanique comprenant une portion, dite de raccord, qui la relie audit ou à chaque dit ancrage et qui inclut une région résistive présentant une première et une deuxième zone d'injection d'un courant électrique pour former un transducteur résistif, ladite région résistive s'étendant principalement dans ladite direction longitudinale à partir dudit ou d'un dit ancrage et étant agencée de telle sorte qu'une flexion de ladite structure mécanique dans ledit plan parallèle au substrat induise dans ladite région résistive une contrainte moyenne non nulle et réciproquement; caractérisé en ce que :

- ladite première zone d'injection est portée par ledit ancrage ; et
- ladite deuxième zone d'injection est portée par un élément conducteur non fixé audit substrat et s'étendant dans une direction dite latérale, sensiblement perpendiculaire à ladite direction longitudinale.

Un autre objet de l'invention est un système microélectromécanique comprenant un premier dispositif microélectromécanique selon un mode de réalisation de l'invention, du type comprenant un circuit électrique d'actionnement, et un second dispositif microélectromécanique selon un mode de réalisation de l'invention, du type comprenant un circuit électrique de détection, dans lequel les structures mécaniques du premier et du deuxième dispositif sont couplées mécaniquement, le circuit d'actionnement du premier dispositif est configuré pour injecter un signal électrique alternatif à une fréquence, dite d'actionnement, superposé à un signal électrique continu ou à une fréquence différente de la fréquence d'actionnement, et le circuit de détection du second dispositif est configuré pour mesurer une variation de résistance à la même fréquence.

Encore un autre objet de l'invention est un système microélectromécanique comprenant un premier dispositif microélectromécanique selon un mode de réalisation de l'invention, du type avec actionnement différentiel à fréquence f/2, et un second dispositif microélectromécanique selon un mode de réalisation de l'invention, du type avec détection différentielle, dans lequel les structures mécaniques du premier et du deuxième dispositif sont couplées mécaniquement, le circuit d'actionnement du premier dispositif est configuré pour injecter un courant électrique alternatif à une première fréquence et le circuit de détection du second dispositif est configuré pour mesurer une variation de résistance à une seconde fréquence, double de la première.

Encore un autre objet de l'invention est un système microélectromécanique comprenant un premier dispositif selon un mode de réalisation de l'invention, du type avec détection, et un second dispositif microélectromécanique selon un mode de réalisation de l'invention, du type avec actionnement, dans lequel les structures mécaniques du premier et du deuxième dispositif sont couplées mécaniquement, le circuit d'actionnement du premier dispositif est configuré pour injecter un signal électrique alternatif à une première fréquence, sans superposition avec un signal électrique continu, et le circuit de détection du second dispositif est configuré pour mesurer une variation de résistance à une seconde fréquence, double de la première.

D'autres caractéristiques, détails et avantages de l'invention ressortiront à la lecture de la description faite en référence aux dessins annexés, donnés à titre d'exemple, dans lesquels :

- Les figures 1 a et 1 b illustrent le calcul de l'impédance d'un actionneur thermique ou capteur piézo-résistif ;
- La figure 2 illustre l'utilisation d'un injecteur latéral pour réduire cette impédance, conformément à l'invention ;
- Les figures 3a et 3b montrent des dispositifs selon deux variantes d'un premier mode de réalisation de l'invention ;
- Les figures 4a, 4b et 4c montrent des dispositifs selon trois variantes d'un deuxième mode de réalisation de l'invention ;
- La figure 5 montre un dispositif selon un quatrième mode de réalisation de l'invention ;
- Les figures 6 à 8 montrent trois systèmes selon un cinquième, un sixième et un septième mode de réalisation de l'invention, respectivement ;
- Les figures 9a et 9b montrent deux images, obtenues par microscopie électronique, d'un système du type représenté schématiquement sur la figure 6 ; et
- La figure 10 illustre les résultats d'une mesure effectuée sur le système des figures 9a et 9b.

Une poutre - ou plus généralement une structure mécanique présentant une forme allongée - microélectromécanique peut être excitée en flexion au moyen d'un actionneur thermique exploitant l'effet Joule et la dilatation thermique. L'actionneur thermique est typiquement constitué par un élément résistif localisé dans une zone de la poutre où la contrainte est d'un seul signe, par exemple au d'un seul côté d'une fibre neutre (plus généralement, il suffit que la contrainte moyenne dans l'élément résistif sont non nulle). Si l'actionneur est suffisamment miniaturisé, il peut atteindre une fréquence de fonctionnement de plusieurs MHz, voire centaines de MHz. Plus précisément, si l'on considère un transport de chaleur dans un fil de longueur L, de conductivité thermique $\kappa$, densité $\rho_m$ et chaleur spécifique $C_\rho$, on peut calculer une fréquence de coupure $\omega_{th}$ selon la formule :

$$\omega_{th} = \frac{\pi\kappa}{\rho_m C_p L^2} \qquad\qquad (1)$$

Par exemple, dans le cas d'un fil en silicium, la fréquence de coupure vaut environ 2,5 MHz pour L=10 $\mu$m, 10 MHz pour L=5 $\mu$m et 250 MHz pour L=1 $\mu$m.

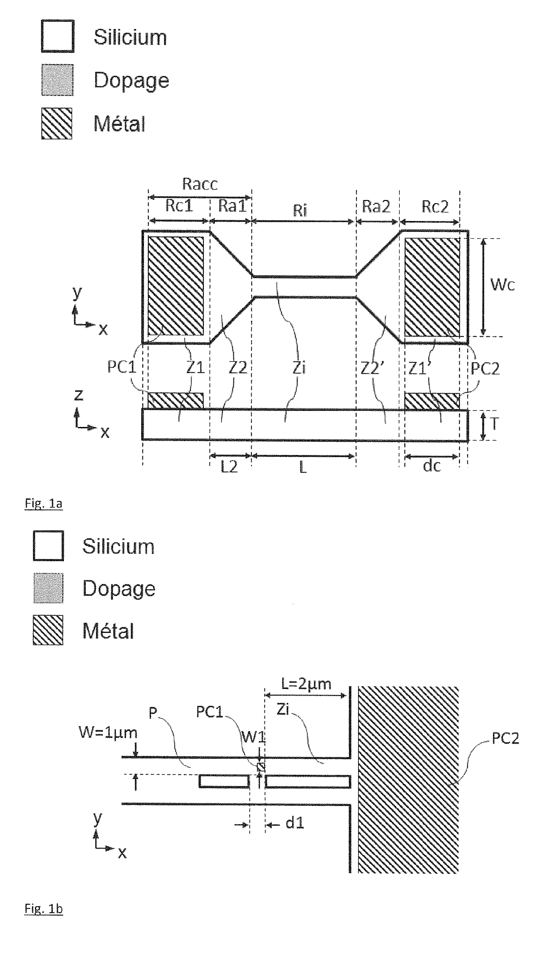

La figure 1a montre deux vues (du haut et du côté) d'un transducteur résistif - pouvant servir d'actionneur thermique ou de capteur piézo-résistif - réalisé en technologie semi-conductrice sur silicium. Le transducteur est constitué par une structure planaire en silicium dopé d'épaisseur T et de résistivité $\rho$, sur laquelle sont déposées deux plots de contact métalliques PC1, PC2 aux extrémités de la structure planaire. Cette dernière comprend cinq zones distinctes : une première zone de contact Z1, recouverte par le plot de contact PC1 et formant un contact ohmique avec elle, une première région de jonction Z2 de longueur L2 se rétrécissant progressivement, une zone de largeur W constante (bien plus faible que la largeur de la zone de contact) et de longueur L, une seconde région de jonction Z2' symétrique de Z2 et une seconde zone de contact Z1' recouverte par le plot de contact PC2 et formant un contact ohmique avec elle. Ces différentes régions présentent une résistance $R_{c1}$, $R_{a1}$, $R_i$, $R_{a2}$, $R_{c2}$ respectivement, et la résistance globale vaut :

$$R = R_{C1} + R_{a1} + R_i + R_{a2} + R_{C2}$$

Le terme « intrinsèque $R_i$ » vaut $\rho \frac{L}{W.T}$ . Pour en diminuer la valeur, on peut utiliser un dopage élevé afin de réduire la résistivité $\rho$, mais seulement jusqu'à un certain point. Dans le silicium, par exemple, on utilise en pratique des dopages limites de quelques $10^{21}$at/cm$^3$. Au delà, des problèmes d'amorphisation ou de limite de solubilité apparaissent.

La résistance d'accès $R_{acc}$ prend en compte le chemin du courant depuis chaque contact métallique jusqu'à la région « intrinsèque » Zi. En première approximation, on peut considérer qu'elle consiste en $R_{c1}+R_{a1}$ à une extrémité du transducteur, et $R_{c2}+R_{a2}$ à l'extrémité opposée. Les contributions $R_{a1}$, $R_{a2}$ prennent en compte le chemin de courant entre chaque contact et la zone intrinsèque et pourront être diminuées en prenant des longueurs L2, L2' les plus faibles possibles.

Les résistances de contact $R_{c1}=R_{c2}=R_c$ peuvent être calculées grâce à la formule :

$$R_C = \frac{\sqrt{\rho_c R_{sq}}}{W_c} * \coth\left(\frac{d_c}{\sqrt{\rho_c / R_{sq}}}\right) \qquad\qquad (2)$$

où :

- $R_{sq}$ : résistance de la couche de semi-conducteur dopé (en Ohms/carré)
- $\rho_c$ : résistance spécifique de contact
- $W_c$ : largeur du contact
- $d_c$ : longueur du contact
- coth : cotangente hyperbolique.

La figure 1b illustre un transducteur résistif TR agencé pour permettre la flexion dans le plan d'une poutre simplement encastrée P, réalisée en silicium. Comme expliqué plus haut, le transducteur doit être agencé d'un côté de la fibre neutre, correspondant ici à l'axe longitudinal de la poutre. La zone de raccord de la poutre au substrat présente deux ouvertures qui lui donnent une structure en forme de « H ». Une demi-jambe du « H » est exploitée pour réaliser le transducteur.

Alors que le plot de contact PC2, réalisé au-dessus du substrat auquel la poutre est encastrée, peut présenter une surface importante, et donc une faible résistance de contact, les dimensions - longueur d1 et surtout largeur W1 - du plot de contact PC1 sont contraintes par celles de l'actionneur, qui à son tour sont déterminées par la fréquence de coupure souhaitée. On prend, par exemple :

- W1 = d1 = 0,5 $\mu$m : largeur du contact,
- $R_{sq}$ = 20 $\Omega$ (ce qui correspond à une couche de silicium d'épaisseur égale à 400 nm dopée bore avec une densité

de 3·10$^{14}$ at/cm$^2$),

- $\rho_c$ = 3·10$^{-7}$ Ω·cm$^2$ (typique pour un contact aluminium sur silicium dopé bore).

Dans ces conditions, la résistance de contact du plot PC1 vaut 208 Ω et domine la résistance intrinsèque, qui vaut environ 40Ω.

Dans ces conditions, la résistance du transducteur ne peut qu'être sensiblement supérieure à 50 Ω, ce qui compromet l'efficacité du transfert de puissance avec des équipements électroniques extérieurs, qui sont généralement calibrés pour s'interfacer avec des charges ou des sources de signal présentant une impédance de cette valeur.

L'équation (2) indique que la résistance de contact peut être diminuée en augmentant les dimensions d$_c$, W$_c$ du contact (d1, W1 dans le cas de la figure 1 b) ; la largeur W$_c$ est particulièrement importante, tandis que la contribution de la longueur d$_c$ devient moins importante dès lors que $d_c > \sqrt{\rho_c / R_{sq}}$. Une idée à la base de la présente invention est que la largeur du contact ohmique peut être augmentée grâce à une zone d'injection, ou « injecteur latéral », qui est une extension latérale conductrice de la poutre, sur laquelle est déposé un plot de contact.

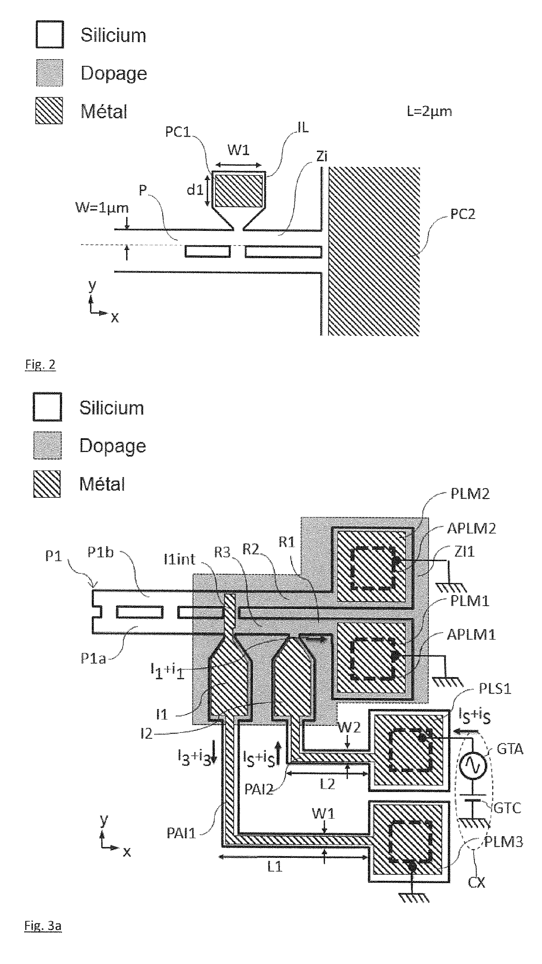

La figure 2 montre la structure de la figure 1b modifiée par l'adjonction d'une zone d'injection ou injecteur latéral IL, réalisée en silicium dopé et s'étendant perpendiculairement à l'axe longitudinal de la poutre P et portant un plot de contact PC1 en métal de dimensions beaucoup plus importantes que dans le cas de la figure 1 b. En prenant W1=5μm et d1=4 μm on obtient Rc=5 Ω. La zone d'injection latérale, en outre, facilite l'évacuation de la chaleur du transducteur. Certes, en principe sa masse peut avoir l'effet indésirable de baisser la fréquence de résonance mais, comme elle est agencée à proximité de l'encastrement de la poutre P, en pratique elle affecte peu le comportement mécanique du dispositif.

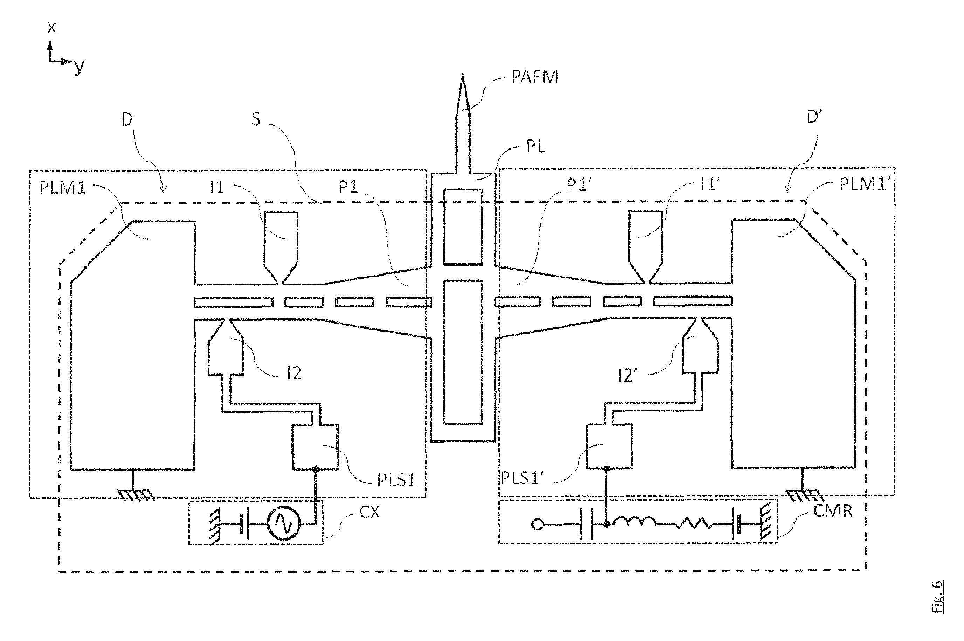

Alors que la figure 2 constitue essentiellement un schéma de principe, les figures 3a à 5 illustrent des dispositifs selon différents modes de réalisation avantageux de l'invention. Les figures 6 à 8 illustrent des systèmes microélectromécaniques comprenant deux dispositifs de ce type, ainsi que l'électronique d'actionnement et de détection associée.

Un dispositif selon l'invention peut être réalisé en technologie silicium sur isolant (SOI, de l'anglais « Silicon On Insulator »). Dans ce cas, il comprend un substrat planaire en silicium relativement épais (épaisseur typiquement comprise entre 350 et 600 μm) sur laquelle est déposée une couche d'oxyde SiO$_2$ dite « oxyde enterré » (ou « BOX », de l'anglais « Buried OXide »), puis une couche de silicium très fine (entre 5 nm et 100 μm, de préférence entre 100 nm et 1 μm) dite couche de dispositif (DL, de l'anglais « Device Layer »), sur laquelle peuvent être déposées des couches métalliques pour réaliser des pistes conductrices et des contacts ; il faut entendre le terme « métal » au sens large de matériau présentant une conductivité de type métallique, incluant par exemple les semi-conducteurs dégénérés. La couche de dispositif peut comprendre des régions intrinsèques, sensiblement isolantes, et des régions dopées, conductrices avec une résistance plus ou moins élevée ; le dépôt de couches métalliques sur les régions dopées de la couche de dispositif peut conduire à la formation de contacts ohmiques.

Certaines régions de la couche de dispositif peuvent être libérées en éliminant l'oxyde enterré sous-jacent ; en particulier, un dispositif selon l'invention comprend une structure libérée s'étendant dans une direction longitudinale (par exemple une poutre), fixée au substrat à l'une de ses extrémités ; les injecteurs latéraux sont également obtenus à partir de régions dopées et libérées de la couche de dispositif. En variante, la structure de type poutre et/ou le ou les injecteurs latéraux peuvent être réalisés en partie dans la couche de dispositif et en partie dans d'autres matériaux.

Les résistances des transducteurs peuvent être obtenues de manières différentes :

- à partir de régions dopées de la couche de dispositif, la concentration en dopant étant choisie pour régler l'impédance (typiquement avec une densité comprise entre 10$^{17}$ et 10$^{21}$ at/cm$^3$, de préférence entre 10$^{19}$ et 5·10$^{20}$ at/cm$^3$) ;
- par dépôt d'une couche mince métallique, par exemple en Pt ou TiN ;
- en siliciure, comme SiPt, AlSi, TiSi, NiSi, WSi$_2$ ;
- en combinant les méthodes précédentes.

Comme expliqué plus haut, ces résistances sont agencées dans des zones de la structure mécanique libérée où la contrainte en flexion dans le plan est d'un seul signe, de telle sorte qu'une flexion de ladite structure dans un plan parallèle au substrat induise dans la résistance une contrainte moyenne non nulle (pour une utilisation du transducteur en détection), et réciproquement pour qu'une contrainte mécanique engendrée par dilatation thermique provoque une telle flexion (pour une utilisation du transducteur en actionnement).

Un dispositif selon l'invention comporte généralement aussi d'autres éléments, tels que des zones d'injection de courant, des lignes de connexion, des plots de contact. Selon les modes de réalisation considérés les zones peuvent être soit totalement libérées, soit partiellement libérées.

L'utilisation de SOI n'est qu'un exemple non limitatif. Un dispositif selon l'invention pourra également être réalisé à partir d'un autre matériau, par exemple une hétérostructure comportant un gaz bidimensionnel d'électrons, ou toute autre structure capable de définir un chemin de courant. On peut utiliser par exemple une structure MOS (métal-oxyde-semi-conducteur), de type normalement passante ou normalement bloquée. Dans ce dernier cas, on peut utiliser une grille électrostatique afin de créer un canal de porteurs. En fait, on peut utiliser tout matériau conducteur, que l'on peut libérer et ayant des propriétés mécaniques assez bonnes pour générer des fréquences de résonances voulues.

Les figures ci-après ne montrent pas tous les détails de réalisation de dispositifs selon l'invention, mais principalement certains aspects tels que la forme et l'agencement des injecteurs latéraux et des zones résistives formant les transducteurs, les interconnexions électriques, les plots de contact et les circuits électriques d'actionnement et de détection.

Le dispositif de la figure 3a comprend une structure mécanique P1, réalisée à l'intérieur de la couche de dispositif d'un empilement SOI et libéré du substrat par gravure de l'oxyde enterré, s'étendant dans une direction x dite longitudinale. La structure P1 n'est pas, dans ce cas, une simple poutre, mais présente une structure composite plus complexe, qui comprend deux poutres longitudinales parallèles P1a, P1b reliées par des traverses.

Tout le silicium à l'intérieur de la région ZI1 est dopé « n+ », ce qui permet la formation de contacts ohmiques par dépôt de couches de métal. Deux dépôts métalliques PLM1, PLM2, de grandes dimensions (par exemple, au moins 5 $\mu$m x 5 $\mu$m) par rapport à la dimension transversale (axe y) de P1 et situés près des ancrages de P1 a et P1 b, sur des régions de la couche de dispositif solidaires du substrat, forment deux plots de contact. Dans l'exemple de la figure 3a, les régions de silicium dopé portant les plots de contacts PLM1, PLM2 comprennent une portion centrale APLM1, APLM2 solidaire du substrat (ancrée) et une région périphérique qui peut être libérée. Dans le mode de réalisation considéré, les portions APLM1, APLM2 constituent en fait les encastrements ou ancrages de la structure mécanique P1.

Deux injecteurs I1 et I2 sont réalisés dans des portions dopées et libérées de la couche de dispositif, solidaires de la structure P1 et recouvertes de couches métalliques formant des contacts ohmiques. Ces injecteurs servent à réduire les résistances de contact d'un transducteur résistif formé par les portions R1 et R3 de la poutre P1 a. Plus précisément, le premier injecteur I1 et le deuxième injecteur I2 s'étendent dans la direction transversale ou latérale y à partir de la poutre I2, le deuxième injecteur I2 étant situé entre le premier injecteur I1 et le plot de contact PLM1. L'injecteur I1 est prolongé par un élément I1 int, également en silicium dopé recouvert de métal, qui s'étend au-dessus des deux poutres P1 a et P1 b. Afin de minimiser leur inertie pour ne pas trop affecter les propriétés mécaniques de la structure P1, les injecteurs devraient être les plus proches possibles des ancrages de ladite structure ; idéalement, la région dite de raccord s'étendant des ancrages jusqu'à l'injecteur le plus éloigné ne devrait pas dépasser un cinquième, voire un dixième, de l'extension de la structure P1 dans la direction longitudinale x.

Les injecteurs I1, I2 sont reliés à des plots de contact respectifs, PLM3, PLS1, par des pistes métalliques portées par des poutres PAI1, PAI2. Ces dernières sont formées dans la couche de dispositif de la structure SOI, sont complètement libérées et présentent une flexibilité élevée (de préférence supérieure à celle de la structure P1) dans la direction y. Dans l'exemple de la figure 3a cette flexibilité est obtenue en prenant des poutres en forme de « L », de largeur W1, W2 faible par rapport à la longueur L2, L3 du bras du « L » orienté selon y ; par exemple, le rapport L2/W2 doit de préférence être supérieur à deux fois le rapport entre la longueur de la région résistive R1 et la largeur de la poutre P1a, et le rapport L1/W1 être supérieur à deux fois le rapport entre la longueur cumulée des régions résistives R1 et R3 et la largeur de la poutre P1a. On peut bien entendu utiliser des formes différentes, par exemple à méandres. Dans de nombreux cas, il s'agira d'obtenir à la fois une grande flexibilité et une faible inertie ; dans d'autres cas la raideur des poutres supportant les pistes métalliques pourra être exploitée pour augmenter la fréquence de résonance du dispositif. Par contre, les plots de contact PLS1, PLM3 présentent une structure semblable à cette de PLM1, PLM2 et sont donc solidaires du substrat, au moins dans leur partie centrale.

On comprend que, dans d'autres modes de réalisation, le nombre de zones d'injection latérales pourrait être supérieur à deux. Ces zones d'injection latérales ne doivent pas nécessairement être agencées au plus près de l'encastrement de la structure longitudinale P1, bien que cela soit souvent considéré avantageux.

Le dispositif de la figure 3a peut être actionné en appliquant au plot PLS1 un signal électrique alternatif à une fréquence f=2$\pi\omega$, de préférence correspondant à une résonance de la structure longitudinale P1 (ou plus généralement proche de cette résonance), généralement superposé à un signal de type continu, tandis que les plots PLM1 et PLM3, et optionnellement aussi PLM2, sont reliés à la masse. Dans l'exemple de la figure 3a, ces signaux sont générés, respectivement, par un générateur de tension alternative GTA connecté en série à un générateur de tension continue GTC, ces deux générateurs formant un circuit d'excitation CX. Un courant $I_s+i_s$ (« I » désignant un courant continu et « i » un courant alternatif) parcourt donc la piste métallique PAI1, est injecté dans la portion de raccord de la poutre P1a via l'injecteur I2, et se repartit en deux composantes. Une première composante $I_1+i_1$ parcourt la région résistive R1 de la poutre P1a et retourne à la masse via le plot PLM1 (qui constitue aussi une zone d'injection ou injecteur, quoique non « latéral », caractérisé par une faible impédance) ; une composante $I_3+i_3$ parcourt la région résistive R3 de la poutre P1a et retourne à la masse via l'injecteur I1, la piste conductrice déposée sur la poutre libérée PAI1 et le plot PLM3. Ces courants produisent un échauffement des régions résistives R1 et R3 et donc une dilatation thermique de la portion de raccord de la poutre P1a, comprenant ces deux régions résistives et les injecteurs I1, I2. Par contre, presque aucun courant ne traverse la région résistive R2 de la poutre P1 b, qui ne se dilate donc pas.

La flexion de la structure P1 est proportionnelle à la puissance thermique $P_{th}$ dissipée dans R1 et R3, qui vaut :

$$P_{th} = \frac{1}{R}\{U^2 + u^2 sin^2 \omega t + 2Uu \cdot \sin \omega t\} \qquad (3)$$

où $R=R_1//R_3$ (en supposant les autres résistances négligeables), U est la tension continue générée par GTC et u l'amplitude de la tension alternative à la fréquence f=$\omega$)/2$\pi$ générée par GTA. On distingue un terme continu sans intérêt, un terme à une fréquence 2f et un terme à la fréquence f. Si on choisit U»u (par exemple U≥10 u), le terme à la fréquence 2f est négligeable, et la structure P1 est mise en oscillation à la fréquence f. En fait, la fonction de la tension continue est de, pour ainsi dire, « amplifier » l'effet de la tension alternative.

Un aspect important de l'invention est que les régions résistives R1 et R3 présentent un rapport longueur/largeur relativement faible (typiquement compris entre 1 et 5, ce qui correspond à une résistance comprise entre 10Ω et 50Ω en supposant une résistance par carré de 10 Ohms, et sont par ailleurs connectées en parallèle. Ainsi, la résistance R=R1//R3 peut présenter une valeur faible ce qui, comme on peut le voir dans l'équation ci-dessus, augmente la puissance dissipée dans l'actionneur thermique.

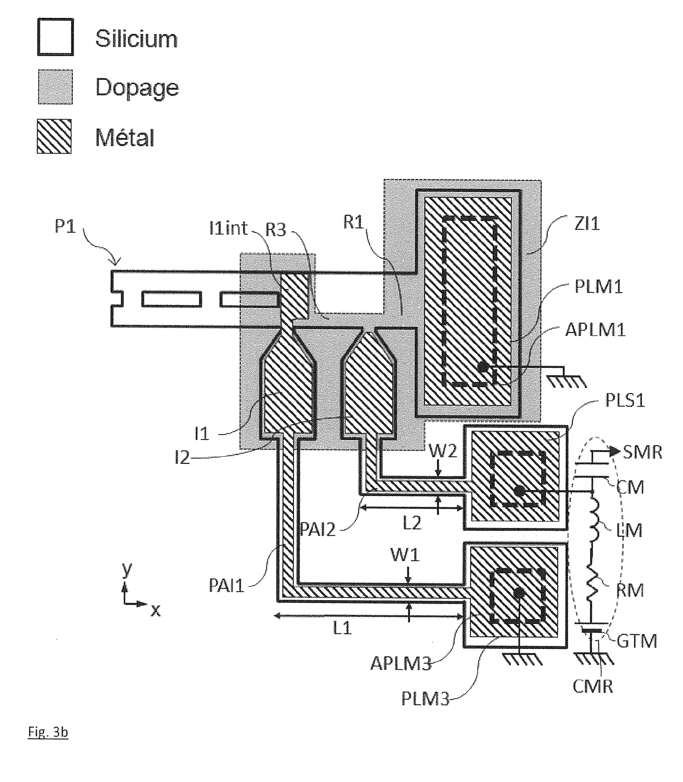

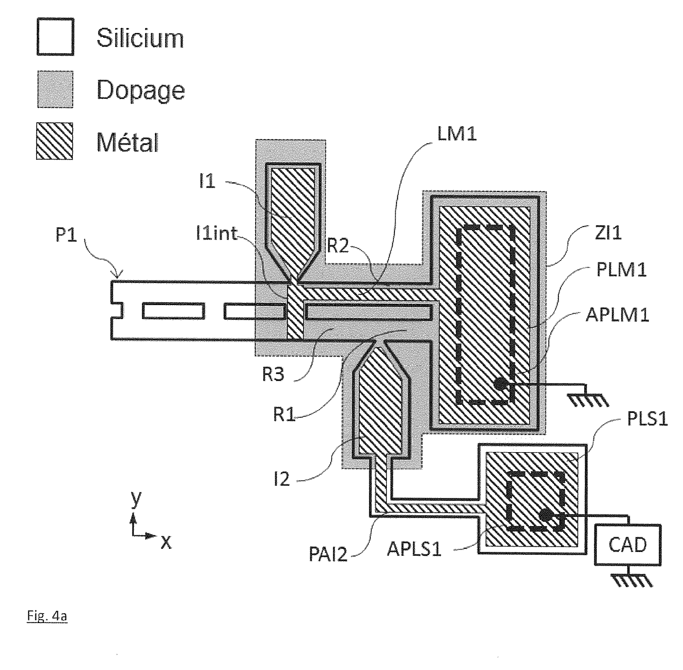

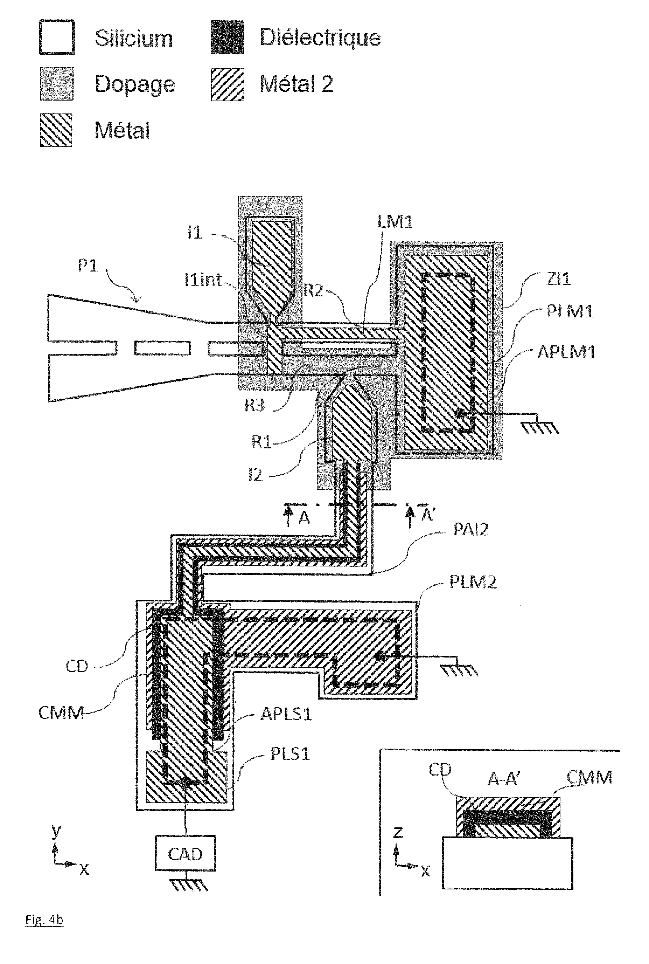

Dans l'exemple de la figure 3a, la région résistive R2 est passive. En variante, elle pourrait être utilisée comme capteur piézo-résistif pour détecter les oscillations de la structure P1, comme dans le cas de la figure 3b, ou porter une piste conductrice reliant I1 int au plot de contact PLM1, comme dans le cas des figures 4a et 4b décrites plus loin.

La couche de métal déposée sur l'injecteur I1int définit un plan de masse, ou tout du moins de très faible potentiel, qui empêche au signal d'actionnement de se propager dans la structure P1 au-delà de la portion de raccord. On peut aussi rajouter un autre plan de masse, si nécessaire, au moyen d'une structure similaire à (I2, PAI2, PLS1) mais située du côté opposé de I1.

Le générateur de tension continue GTC pourrait être remplacé par un générateur de courant continu, ou être absent - auquel cas il conviendrait d'utiliser un courant alternatif d'excitation à une fréquence f/2 pour obtenir, via le terme quadratique de l'équation (3), une excitation de la structure mécanique P1 à une fréquence f proche ou identique à sa fréquence de résonance $f_0$. Le générateur de tension alternative pourrait être remplacé par un générateur de courant alternatif ou par un générateur radiofréquence. On peut même envisager un fonctionnement quasi-statique, n'utilisant pas de générateur alternatif.

En variante, le circuit d'excitation CX pourrait être remplacé par un circuit de mesure de résistance, permettant la détection d'une oscillation de la structure P1 se traduisant par une variation de la résistance de R1//R3 par effet piézo-résistif. Ce cas sera décrit plus particulièrement en référence à la figure 3b. Il est également possible d'utiliser un circuit permettant à la fois l'excitation de l'oscillation de la structure P1 par actionnement thermique et la détection de cette oscillation par effet piézo-résistif ; en particulier, cela est possible si, comme cela a été évoqué plus haut, l'excitation est obtenue en utilisant un courant alternatif à la fréquence f/2 ; dans ce cas, le signal d'excitation (f/2) et le signal de mesure (f) peuvent être séparés par des filtres électriques. Cependant, il ne s'agit pas d'un mode de réalisation préféré.

Le dispositif de la figure 3b constitue une variante de celui de la figure 3a. Les principales différences sont les suivantes :

- Les résistances R1, R3 ne sont pas définies par gravure, mais uniquement par la forme de la région de dopage ZI1 ; il n'y a donc pas de région résistive R2.
- Le plot de contact PLM2 est absent, tandis que le plot PLM1 est plus large, s'étendant sur toute la région d'ancrage de la structure P1.
- Les générateurs de tension GTC, GTA sont remplacés par un circuit de mesure de la résistance CMR, permettant d'utiliser les régions résistives R1, R3 comme capteurs piézo-résistifs.

Le circuit CMR comprend un générateur de tension - ou de courant - continue ou lentement variable (fréquence non supérieure à f/10) GM relié au plot PLS1 par l'intermédiaire d'une résistance RM et d'une inductance LM en série (la résistance RM peut être simplement la résistance interne du générateur) ; une telle topologie est connue sous le nom de « T de polarisation » (« bias tee » en anglais). Les fluctuations de tension, à la fréquence f, induites par les variations périodiques de résistance de l'ensemble R1//R3 sont prélevées sur une sortie SMR par l'intermédiaire d'un condensateur de liaison CM. En variante, il serait possible d'utiliser un générateur de mesure à haute fréquence (fréquence F supérieure ou égale à 10f), et détecter un signal de mesure à F+f ou F-f qui est ensuite démodulé.

Dans le dispositif de la figure 4a, seul l'injecteur I2 est connecté à un plot de connexion (PLS1) par une ligne métallique portée par une poutre flexible PAI1, tandis que l'injecteur I1 est relié au plot APLM1, qui recouvre l'ancrage de la structure P1, par une ligne métallique - ou en tout cas très conductrice - LM1 s'étendant au-dessus de la région résistive R2 qui est ainsi court-circuitée. En variante, on pourrait avoir deux plots de contact distincts en correspondance des encastrements de P1, comme dans le cas de la figure 3a ; dans ce cas, grâce à la présence de LM1, les deux plots auraient une fonction de plot de masse.

Le plot PLM1 est relié à la masse, tandis que le plot PLS1 est relié à un circuit d'actionnement et/ou de détection qui peut, par exemple, présenter le fonctionnement décrit plus haut en référence aux figures 3a et 3b.

L'utilisation de la ligne métallique au-dessus de R2 est contre-intuitive, car elle est soumise à une contrainte de signe opposé à celle agissant sur R1 et R3. En effet, la couche LM1 a un facteur de jauge beaucoup plus faible que R1, R3 et comme il s'agit de métal ou d'une couche très conductrice, elle court-circuite R2. Donc, le courant dans R1 et R3 va dominer la réponse piézo-résistive.

En utilisation d'actionneur, on pourrait objecter que la puissance Joule passant du côté de R2 va contribuer à échauffer le bras supérieur de la poutre alors que l'on veut uniquement échauffer le côté R1, R3. Mais en fait, comme LM1 est en métal, le potentiel sur I1int est proche de 0. Le produit U*I est donc extrêmement faible comparé au produit U*I dans R3 et R1 qui sont alimentés par le potentiel de I2, non nul.

On remarque que, dans le dispositif de la figure 4a, l'injecteur I1 s'étend dans une direction latérale opposée à celle de I2, ce qui a par effet d'équilibrer P1. Un tel agencement, optionnel, peut également être utilisé dans les autres modes de réalisation.

La figure 4b illustre une variante du dispositif de la figure 4a, dans laquelle une couche diélectrique CD, par exemple en oxyde de silicium ($SiO_2$) ou en parylène, recouvre l'injecteur I2 et la ligne de signal reliant cet injecteur au plot de contact de signal PLS1, et optionnellement une partie du plot lui-même. Une couche métallique CMM est déposée au-dessus de cette couche diélectrique et reliée à la masse via un plot de contact PLM2 (ou, en variante, le plot PLM1). Cela permet d'isoler la ligne de signal des perturbations électromagnétiques. Les couches CMM et CD sont particulièrement bien visibles sur l'insert, qui montre une vue en coupe de la structure selon la ligne A-A'.

On remarque également la forme doublement coudée de la poutre flexible PAI2.

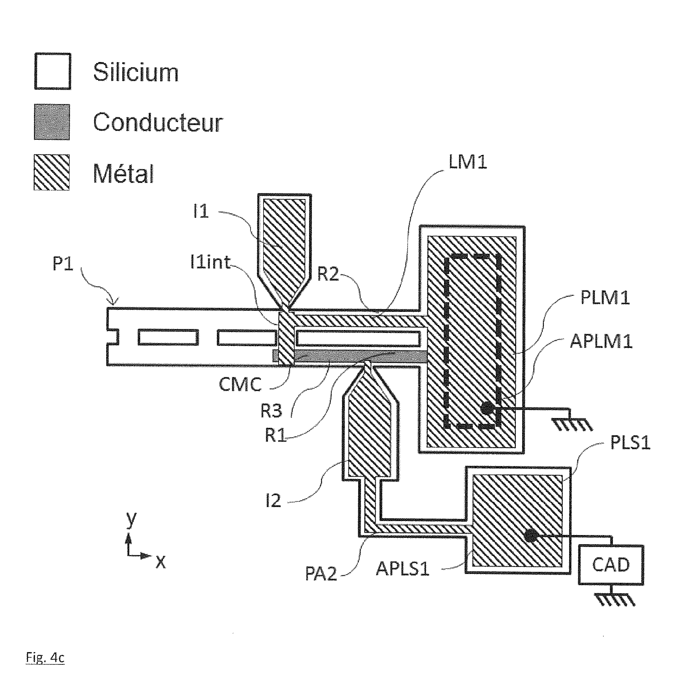

La figure 4c illustre une variante dans laquelle il n'y plus de zone implantée ZI1 et les résistances R1 et R3 sont constituées par une couche mince conductrice CMC, réalisée par exemple en un métal déposé, tel que le platine, par un siliciure (alliage de silicium et d'un métal comme le platine, l'aluminium, etc), ou par une implantation très localisée.

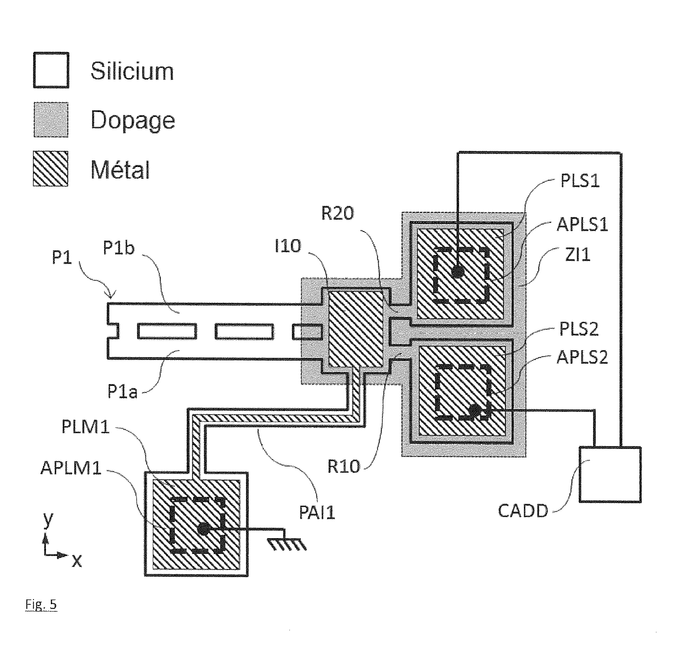

Le dispositif de la figure 5 permet un fonctionnement en mode différentiel. Dans ce dispositif, la structure longitudinale P1 présente la même structure composite que dans le cas de la figure 3a : elle comporte deux poutres longitudinales parallèles P1a, P1b encastrées séparément. Deux métallisations forment des plots de contact PLS1, PLS2 au-dessus des ancrages APLS1, APLS2 de ces poutres. Un injecteur unique 110 s'étend au-dessus des portions de raccord, dopées, des poutres P1a, P1b, et est relié par une ligne conductrice déposée sur une poutre libérée flexible PAI1 à un plot de contact PLM1 relié à la masse. Deux régions résistives R10, R20 sont définies dans le portions de raccord de P1a et de P1b, respectivement. On comprend que, lors d'une utilisation du dispositif en mode de détection, une flexion de la structure P1 dans le plan affecte la résistance de R10 et de R20 de manière opposée ; on peut donc effectuer une mesure de résistance différentielle pour détecter les oscillations de P1 avec une sensibilité accrue.

Réciproquement, on peut réaliser un actionnement différentiel en appliquant à PLS1 et PLS2 des tensions alternative en opposition de phase, superposées à des tensions continues - voire des tensions alternatives en quadrature de phase, à une fréquence égale à la moitié de la fréquence d'oscillation de P1 que l'on recherche, en l'absence de composante continue.

Sur la figure 5, la référence CADD désigne un circuit d'actionnement et/ou détection différentiel.

La structure longitudinale P1, actionnée en flexion, peut à son tour agir sur un autre composant micromécanique d'un système plus complexe, en provoquant et/ou en détectant son mouvement ou sa déformation. Des exemples de tels systèmes sont illustrés par les figures 6 à 10.

La figure 6 représente un système microélectromécanique complexe - une sonde pour microscopie à force atomique (AFM) - mettant en oeuvre deux dispositifs selon l'invention. La sonde pour microscopie à force atomique comprend une pointe d'AFM, PAFM, portée par une poutre PL qui fait saillie du bord d'un substrat S. La poutre PL peut osciller dans sa direction longitudinale (x), parallèlement au plan du substrat. Pour ce faire, elle est suspendue à l'aide de deux bras latéraux P1, P1' appartenant à des dispositifs du type de la figure 4a. Les références PLM1, PLS1, I1, I2 désignent les plots de contact et les injecteurs du premier dispositif D, les références PLM1', PLS1', I1', I2' les éléments correspondants du second dispositif D'.

Le premier dispositif D est relié à un circuit d'excitation CX et sert à l'actionnement de la poutre PL ; le second dispositif D' est relié à un circuit de mesure CMR pour détecter les oscillations de ladite poutre.

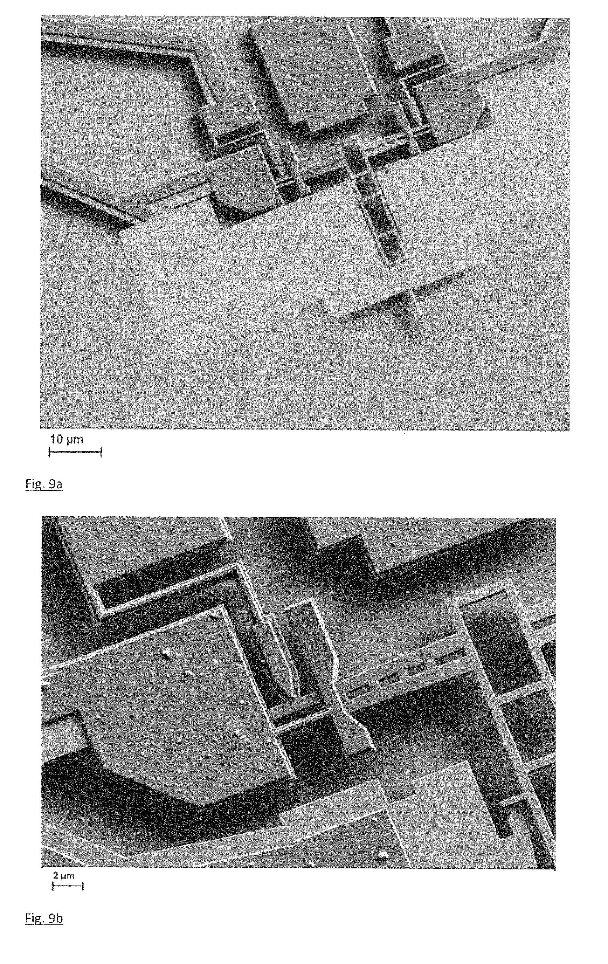

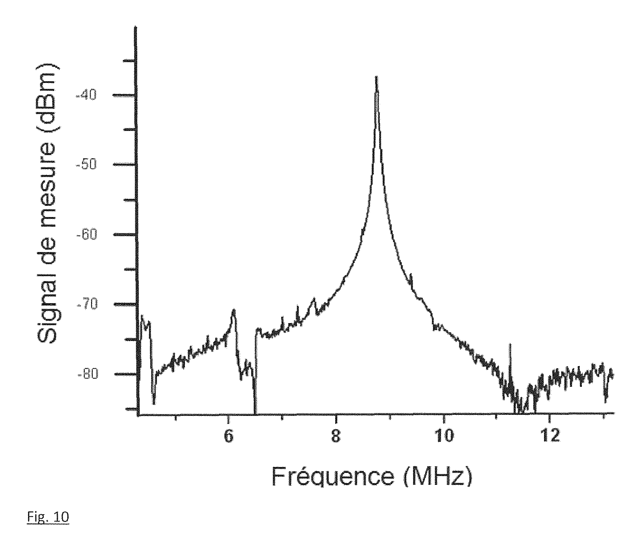

Un système de ce type a été réalisé en technologie SOI. La figure 9a en montre une image obtenue par microscopie électronique (certaines parties de l'image, sans intérêt pour la compréhension de l'invention, sont cachées). La figure 9b est une vue de détail montrant les injecteurs I1, I2. La figure 10 illustre les résultats d'une mesure effectuée en excitant l'oscillation du système par injection d'un signal électrique d'amplitude 2dBm, dont la fréquence balaye la plage 2 - 6,5 MHz. L'oscillation mécanique du système, à une fréquence double de celle du signal d'excitation, est détectée en appliquant une tension de polarisation continue de 0,2 V à un circuit de détection. La courbe de mesure, reproduite sur la figure, montre un pic de type lorentzien, avec une fréquence de résonance à 8,78 MHz.

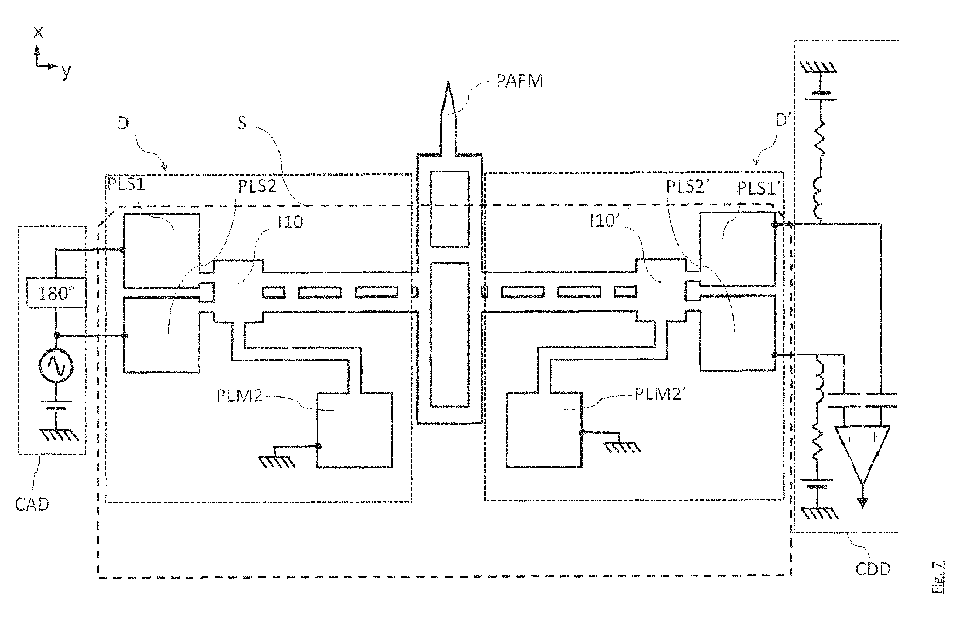

La figure 7 montre un système microélectromécanique analogue à celui de la figure 6, mais utilisant deux dispositifs du type de la figure 5, permettant un actionnement et une détection de type différentiel.

Les références PLM2, PLS1, PLS2 110 désignent les plots de contact et les injecteurs du premier dispositif D, les références PLM2', PLS1', PLS2', 110' les éléments correspondants du second dispositif D'. Le dispositif D est utilisé en actionnement ; ses plots PLS1, PLS2 sont reliés à un circuit d'actionnement différentiel CAD pour recevoir deux signaux électriques alternatif de même fréquence et en opposition de phase, obtenus en utilisant un générateur commun et un déphaseur de 180°, superposés à une composante continue. Le dispositif D' est utilisé en détection ; ses plots PLS1', PLS2' sont reliées aux entrées d'un circuit de détection différentielle CDD.

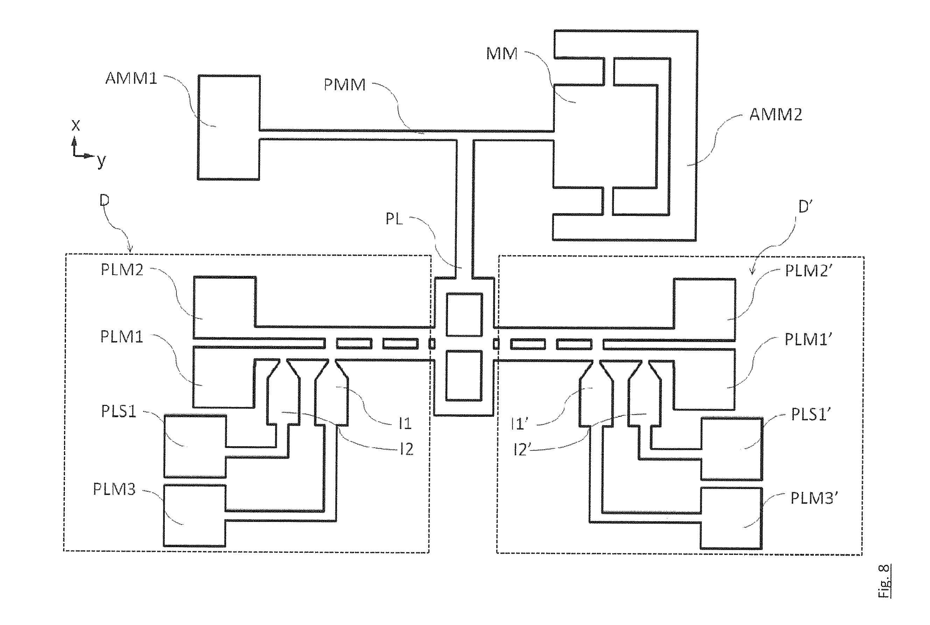

La figure 8 illustre un système microélectromécanique de type accéléromètre utilisant deux dispositifs D, D' du type de la figure 3b. Les références I1, I2, PLM1, PLM2, PLS1, PLS2 représentent les injecteurs et les plots de contact du dispositif D, les références I1', I2', PLM1', PLM2', PLS1', PLS2' les mêmes éléments du dispositif D'.

Le système comprend un élément de type poutre PL, s'étendant dans une direction y, connecté à une masse mobile MM par l'intermédiaire d'une autre poutre PMM s'étendant dans la direction perpendiculaire x. Cette masse mobile est ancrée en AMM1 et AMM2. Un des deux dispositifs, D par exemple, permet de mettre la poutre PMM en oscillation tandis que le second système, D' par exemple, mesure la fréquence de résonance de ladite poutre. Lors d'une accélération la masse mobile se déplace, comprime ou étire la poutre PMM et induit une modification, détectable, de sa fréquence de résonance.

**Revendications**

1. Dispositif microélectromécanique comprenant une structure mécanique (P1) s'étendant principalement selon une direction (x) dite longitudinale, reliée à un substrat planaire (S) par au moins un ancrage (APLM1, APLM2) situé à l'une de ses extrémités selon ladite direction longitudinale et susceptible de fléchir dans un plan parallèle au substrat, ladite structure mécanique comprenant une portion, dite de raccord, qui la relie audit ou à chaque dit ancrage et qui inclut une région résistive (R1) présentant une première (PLM1) et une deuxième (I2) zone d'injection d'un courant électrique pour former un transducteur résistif, ladite région résistive s'étendant principalement dans ladite direction longitudinale à partir dudit ou d'un dit ancrage et étant agencée de telle sorte qu'une flexion de ladite structure mécanique dans ledit plan parallèle au substrat induise dans ladite région résistive une contrainte moyenne non nulle et réciproquement; **caractérisé en ce que** :

   - ladite première zone d'injection (PLM1) est portée par ledit ancrage (APLM1) ; et
   - ladite deuxième zone d'injection (I2) est portée par un élément conducteur non fixé audit substrat et s'étendant dans une direction dite latérale (y), sensiblement perpendiculaire à ladite direction longitudinale ;

   le substrat (S) étant parallèle à un plan défini par les directions longitudinale (x) et latérale (y).

2. Dispositif microélectromécanique selon la revendication 1 dans lequel ladite région résistive présente également au moins une troisième zone d'injection (I1) d'un courant électrique portée par un élément conducteur non fixé audit substrat, s'étendant dans ladite direction latérale et distinct de l'élément conducteur portant ladite deuxième zone d'injection, la deuxième zone d'injection étant agencée entre la première et la troisième zone d'injection.

3. Dispositif microélectromécanique selon l'une des revendications précédentes dans lequel ladite structure mécanique est réalisée en matériau semi-conducteur et lesdites zones d'injection comprennent des couches métalliques déposées au-dessus de portions respectives de ce matériau semi-conducteur et formant des contacts ohmiques.

4. Dispositif microélectromécanique selon l'une des revendications précédentes dans lequel au moins une dite zone d'injection (I1, I1 int) s'étend sur toute la largeur de ladite portion de raccord, au-delà de l'étendue de ladite région résistive.

5. Dispositif microélectromécanique selon l'une des revendications précédentes, dans lequel au moins ladite deuxième zone d'injection est reliée à un plot de contact (PLM3) solidaire dudit substrat par l'intermédiaire d'un élément en forme de poutre (PAI1) non fixé audit substrat et présentant une flexibilité dans ladite direction latérale.

6. Dispositif microélectromécanique selon la revendication 5, dans lequel ledit élément en forme de poutre présente une flexibilité dans ladite direction latérale supérieure à celle de la structure mécanique.

7. Dispositif microélectromécanique selon l'une des revendications précédentes dans lequel ladite portion de raccord de la structure mécanique comprend au moins deux poutres parallèles (P1a, P1 b), orientées selon ladite direction longitudinale et disposées de part et d'autre d'une fibre neutre de la portion de raccord, ladite région résistive étant incluse dans l'une desdites poutres.

8. Dispositif microélectromécanique selon l'une des revendications précédentes dans lequel ladite portion de raccord de la structure mécanique comprend une poutre unique (P1) orientée selon ladite direction longitudinale, ladite région résistive étant agencée sur un côté de ladite poutre, le reste de la poutre étant réalisé en matériau présentant une résistivité électrique plus élevée.

9. Dispositif microélectromécanique selon l'une des revendications précédentes comprenant également un circuit électrique de détection (CMR), configuré pour mesurer une résistance électrique variable dans le temps de ladite région résistive entre deux desdites zones d'injection.

10. Dispositif microélectromécanique selon l'une des revendications 1 à 9 comprenant également un circuit électrique d'actionnement (CX), configuré pour injecter un signal électrique alternatif dans ladite région résistive par l'intermédiaire desdites zones d'injection.

11. Dispositif microélectromécanique selon l'une des revendications 1 à 8 dans lequel ladite structure mécanique comprend deux régions résistives (R10, R20) incluses dans ladite portion de raccord et agencées de telle sorte qu'une flexion de ladite portion de raccord dans un plan parallèle au substrat induise dans lesdites régions résistives des contraintes moyennes non nulles et de signe opposé, chaque dite région résistive présentant une dite première (PLS1, PLS2) et une dite deuxième (I10) zone d'injection d'un courant électrique, lesdites premières zones d'injection d'un courant électrique étant disjointes.

12. Dispositif microélectromécanique selon la revendication 11 comprenant également un circuit électrique de détection (CADD), configuré pour mesurer une différence, variable dans le temps, entre les résistances des deux premières zones d'injection d'un courant électrique.

13. Dispositif microélectromécanique selon la revendication 11 comprenant également un circuit électrique d'actionnement (CADD) configuré pour injecter des signaux électriques alternatif à une même fréquence, dite d'actionnement, et en opposition de phase, superposés à un signal électrique continu ou à une fréquence différente de ladite fréquence d'actionnement, dans lesdites régions résistives par l'intermédiaire desdites zones d'injection.

14. Dispositif microélectromécanique selon la revendication 11 comprenant également un circuit électrique d'actionnement (CADD) configuré pour injecter des signaux électriques alternatif à une même fréquence, dite d'actionnement, et en quadrature de phase, sans superposition avec un signal électrique continu ou à une fréquence différente de ladite fréquence d'actionnement, dans lesdites régions résistives par l'intermédiaire desdites zones d'injection.

15. Système microélectromécanique comprenant un premier dispositif microélectromécanique (D) selon la revendication 9 et un second dispositif microélectromécanique (D') selon la revendication 10, dans lequel les structures mécaniques (P1, P1') du premier et du deuxième dispositif sont couplées mécaniquement, le circuit d'actionnement (CX) du premier dispositif est configuré pour injecter un signal électrique alternatif à une fréquence, dite d'actionnement, superposé à un signal électrique continu ou à une fréquence différente de la fréquence d'actionnement, et le circuit de détection (CMR) du second dispositif est configuré pour mesurer une variation de résistance à la même fréquence.

16. Système microélectromécanique comprenant un premier dispositif microélectromécanique selon la revendication 14 et un second dispositif microélectromécanique selon la revendication 12, dans lequel les structures mécaniques du premier et du deuxième dispositif sont couplées mécaniquement, le circuit d'actionnement du premier dispositif est configuré pour injecter un courant électrique alternatif à une première fréquence et le circuit de détection du second dispositif est configuré pour mesurer une variation de résistance à une seconde fréquence, double de la première.

17. Système microélectromécanique comprenant un premier dispositif microélectromécanique (D) selon la revendication 9 et un second dispositif microélectromécanique (D') selon la revendication 10, dans lequel les structures mécaniques (P1, P1') du premier et du deuxième dispositif sont couplées mécaniquement, le circuit d'actionnement (CX) du premier dispositif est configuré pour injecter un signal électrique alternatif à une première fréquence, sans superposition avec un signal électrique continu, et le circuit de détection (CMR) du second dispositif est configuré pour mesurer une variation de résistance à une seconde fréquence, double de la première.

□ Silicium

▨ Dopage

▨ Métal

Fig. 1a

□ Silicium

▨ Dopage

▨ Métal

Fig. 1b

Fig. 2

Fig. 3a

Fig. 3b

Fig. 4a

Silicium

Dopage

Métal

Diélectrique

Métal 2

P1

I1

I1int

R2

LM1

ZI1

PLM1

APLM1

R3

R1

I2

A   A'

PAI2

PLM2

CD

CMM

APLS1

PLS1

CAD

y
x

CD   A-A'   CMM

z
x

Fig. 4b

Fig. 4c

Silicium

Dopage

Métal

Fig. 5

Fig. 6

Fig. 7

Fig. 8

10 µm

Fig. 9a

2 µm

Fig. 9b

Fig. 10

Europäisches
Patentamt

European
Patent Office

Office européen
des brevets

# RAPPORT DE RECHERCHE EUROPEENNE

Numéro de la demande

EP 16 19 3853

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | FR 2 964 653 A1 (COMMISSARIAT ENERGIE ATOMIQUE [FR]) 16 mars 2012 (2012-03-16) | 1-6, 8-10, 15-17 | INV. G01Q10/04 B81B3/00 |
| A | * figure 7 * <br> * page 13, ligne 6 - ligne 23 * <br> ----- | 7,11-14 | G01Q20/04 |
| X | EP 1 316 977 A2 (NORTEL NETWORKS LTD [CA]) 4 juin 2003 (2003-06-04) | 1,3,4,7, 9,10, 15-17 | |
| A | * figure 2 * <br> * alinéa [0035] * <br> ----- | 2,5,6,8, 11-14 | |
| X | WO 2011/038470 A1 (AMG TECHNOLOGY LTD [BG]; STAVROV VLADIMIR [BG]) 7 avril 2011 (2011-04-07) | 1,3,4, 8-14 | |
| A | * figures 10A-10C * <br> * page 34, ligne 3 - ligne 28 * <br> ----- | 2,5-7, 15-17 | |
| X,D | BEARDSLEE L A ET AL: "Thermal Excitation and Piezoresistive Detection of Cantilever In-Plane Resonance Modes for Sensing Applications", JOURNAL OF MICROELECTROMECHANICAL SYSTEMS, IEEE SERVICE CENTER, US, vol. 19, no. 4, 1 août 2010 (2010-08-01), pages 1015-1017, XP011312002, ISSN: 1057-7157 | 1,3,4, 8-10 | DOMAINES TECHNIQUES RECHERCHES (IPC) <br><br> G01Q B81B G01P |
| A | * figure 1 * <br> * le document en entier * <br> ----- | 2,5-7, 11-17 | |

Le présent rapport a été établi pour toutes les revendications

| Lieu de la recherche | Date d'achèvement de la recherche | Examinateur |
|---|---|---|
| Berlin | 13 février 2017 | Polesello, Paolo |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)

**EP 3 159 703 A1**

## ANNEXE AU RAPPORT DE RECHERCHE EUROPEENNE
## RELATIF A LA DEMANDE DE BREVET EUROPEEN NO.

EP 16 19 3853

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

13-02-2017

| Document brevet cité au rapport de recherche | | Date de publication | Membre(s) de la famille de brevet(s) | | Date de publication |
|---|---|---|---|---|---|
| FR 2964653 | A1 | 16-03-2012 | EP<br>FR<br>US<br>WO | 2616386 A1<br>2964653 A1<br>2013154440 A1<br>2012034949 A1 | 24-07-2013<br>16-03-2012<br>20-06-2013<br>22-03-2012 |
| EP 1316977 | A2 | 04-06-2003 | CA<br>EP<br>US | 2413387 A1<br>1316977 A2<br>2003101721 A1 | 30-05-2003<br>04-06-2003<br>05-06-2003 |
| WO 2011038470 | A1 | 07-04-2011 | BG<br>WO | 66424 B1<br>2011038470 A1 | 31-03-2014<br>07-04-2011 |

EPO FORM P0460

Pour tout renseignement concernant cette annexe : voir Journal Officiel de l'Office européen des brevets, No.12/82

24

**RÉFÉRENCES CITÉES DANS LA DESCRIPTION**

**Littérature non-brevet citée dans la description**

- **J. H. COMTOIS ; V. M. BRIGHT ; M. W. PHIPPS.** *Thermal microactuators for surface-micromachining processes,* 15 Septembre 1995, vol. 15

- **L. A. BEARDSLEE ; A. M. ADDOUS ; S. HEINRICH ; F. JOSSE ; I. DUFOUR ; O. BRAND.** Thermal Excitation and Piezoresistive Detection of Cantilever In-Plane Resonance Modes for Sensing Applications. *Journal of Microelectromechanical Systems,* Août 2010, vol. 19 (4